# EUROPEAN PATENT APPLICATION

(11) **EP 4 485 798 A1**
(43) Date of publication of application: **01.01.2025**
(21) Application number: 23182262.8
(22) Date of filing: 29.06.2023
(51) Int. Cl.: H03F 3/191, H03F 1/42, H03F 1/56, H03F 3/19, H03F 3/45, H03G 1/00, H03F 3/193

(54) **BROADBAND AMPLIFIER PEAKING CONTROL**

(71) Applicant: Huawei Technologies Co., Ltd., Shenzhen, Guangdong 518129 (CN)
(72) Inventor: Veni, Simone, 80992 Munich (DE); Schembari, Filippo, 80992 Munich (DE); Romanò, Luca, 80992 Munich (DE)
(74) Representative: MERH-IP Matias Erny Reichl Hoffmann Patentanwälte PartG mbB

(57) **Abstract**

In some examples, a resonance network for an amplifier (204) comprises an input terminal (A) and an output terminal (B), a resonant circuit comprising a first inductor (103), wherein the first inductor (103) is connected between the input terminal (A) and the output terminal (B), and a tuning circuit (104) comprising a second inductor (110), wherein the second inductor (110) is magnetically coupled to the first inductor (103), and wherein the tuning circuit (104) comprises a tunable resistive element (111) connected in parallel to the second inductor (110).

## Description

### TECHNICAL FIELD

The present invention relates, in general, to broadband amplifiers for optical, wireline and wireless communications. Aspects of the disclosure relate to tuning amplitude peaking in or via a resonance network.

### BACKGROUND

The ever-increasing demand for higher data-rates in optical communications sets tight requirements on the achievable signal bandwidth of transimpedance amplifiers (TIAs) and drivers, which nowadays must exceed several tens of GHz (and likely also 100GHz).

An amplifier whose frequency response exhibits a certain degree of amplitude peaking is a common choice in broadband RF transceivers. This allows exploiting signal pre-equalization in receivers (e.g., link loss compensation in wireline applications, photodiode signal amplification in optical applications) and to compensate the optical modulator losses in optical links. A typical broadband amplifier consists of several stages in cascade, where one or more of them exploit variable peaking, i.e., they feature peaking tunability.

Different circuit techniques to tune the amplitude peaking of broadband amplifier exist.

Practically, the addition of such tunability deteriorates either the amplifier bandwidth, the "original" amplifier peaking (i.e., the peaking amplitude of its frequency response when no tuning circuit is employed), or even the amplifier linearity.

### SUMMARY

An objective of the present disclosure is to provide a novel peaking tuning technique which improves both the peaking and bandwidth performance of a broadband amplifier with respect to the state of the art. The present disclosure is particularly tailored to fully integrated highfrequency broadband amplifiers where low peaking degradation and high bandwidth are required, such as (but not limited to) broadband driver amplifiers for optical communications, broadband transimpedance amplifiers for optical communications, and broadband amplifiers for wideband RF transceivers (i.e., wireline and wireless).

The foregoing and other objectives are achieved by the features of the independent claims.

Further implementation forms are apparent from the dependent claims, the description and the Figures.

A first aspect of the disclosure provides a resonance network for an amplifier, comprising an input terminal and an output terminal, a resonant circuit comprising a first inductor, wherein the first inductor is connected between the input terminal and the output terminal, and a tuning circuit comprising a second inductor, wherein the second inductor is magnetically coupled to the first inductor, and wherein the tuning circuit comprises a tunable resistive element connected in parallel to the second inductor.

Accordingly, a tuning circuit for tuning the amplitude peaking of an amplifier may be provided without non-negligently loading the output nodes of the amplifier. As there is nothing physically connected in parallel to the peaking inductor which would detrimentally load the amplifier (i.e., parasitic capacitances), the maximum achievable bandwidth and amplitude peaking can be improved.

In an implementation of the first aspect, the tuning circuit can modify a value of inductance of the first inductor by varying a value of the tunable resistive element. The tunable resistive element can comprise a variable resistor, wherein the variable resistor can be controlled by a control voltage, whereby to provide a variable resistance. In an example, the tunable resistive element can comprise a metal-oxide-semiconductor, MOS, transistor, and/or a bipolar junction transistor, BJT, wherein a channel resistance of the MOS transistor and/or of the BJT can be varied, whereby to provide a variable resistance.

The variable resistor can comprise a plurality of resistive units, wherein the plurality of resistive units can each be controllable by the control voltage. The control voltage can comprise an analogue control voltage or a discrete control voltage.

The resonance network can comprise a plurality of resonant circuits, wherein the plurality of resonant circuits can be connected to one another in series or in parallel. The plurality of resonant circuits can be connected to active section of an amplifier or amplifiers in series or in parallel.

In an example, the first inductor can comprise a shunt inductor or an inductor in series with the input terminal and the output terminal, also referred to as a `series inductor'. The resonance network can further comprise at least one differential pair of transistors. The at least one differential pair of transistors can comprise cascode transistors.

A second aspect of the disclosure provides an amplifier comprising a resonance network as provided according to the first aspect.

In an implementation of the second aspect, the amplifier can comprise multiple resonance networks, wherein the multiple resonance networks are connected to one another in parallel or in series. The amplifier can comprise one of a broadband amplifier, a transimpedance amplifier, and a driver amplifier.

A third aspect of the disclosure provides a method of tuning amplitude peaking in a resonance network for an amplifier, the resonance network comprising an input terminal, an output terminal, and a resonant circuit, wherein the resonant network comprises a first inductor connected between the input terminal and the output terminal, the method comprising providing a tuning circuit, wherein the tuning circuit comprises a second inductor magnetically coupled to the first inductor, and a tunable resistive element connected in parallel to the second inductor, and varying a value of the tunable resistive element to change an value of inductance of the first inductor.

In an implementation of the third aspect, the tunable resistive element can comprise a variable resistor and/or a metal-oxide-semiconductor, MOS, transistor and/or a bipolar junction transistor, BJT, and the method can further comprise varying a value of the variable resistor using a control voltage, and/or varying a value of a channel resistance of the MOS transistor and/or of the BJT.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of a resonance network according to an example;
Figure 2 is a schematic representation of a resonance network according to another example;
Figure 3 is a schematic representation of a resonance network according to another example;
Figure 4 is a schematic representation of a resonance network according to another example;
Figure 5 is a schematic representation of a resonance network according to another example;
Figure 6 is a schematic representation of a resonance network according to another example;
Figure 7 is a schematic representation of a resonance network according to another example;
Figure 8 is a schematic representation of a resonance network according to another example; and
Figure 9 is a flow chart of a method of tuning amplitude peaking in a resonance network according to an example.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

In order to tune the amplitude peaking of an amplifier (for example, a broadband amplifier), various tuning circuits may be used. In practice, the addition of such tuning circuits deteriorates either the amplifier's bandwidth, the "original" amplifier peaking (i.e., the peaking amplitude of the amplifier's frequency response when no tuning circuit is present), or even the amplifier's linearity. Ideally, it is desirable that the auxiliary circuitry needed to implement the tuneable peaking within the broadband amplifier does not impair (i.e., load) the amplifier's original/inherent transfer function (that is, the transfer function without any auxiliary circuitry for peaking control).

When a tuning circuit is turned off (i.e., the configuration in which the amplifier's transfer function should exhibit its maximum peaking amplitude), the amplifier's transfer function should ideally be practically identical to the original transfer function. In other words, the bandwidth and the amplitude peaking deterioration should be negligible. Similarly, when the tuning circuit is turned on (i.e., the configuration in which the amplifier's transfer function should exhibit its maximum peaking amplitude), the amplifier's bandwidth ideally would not be lowered.

In the prior art, a switchable or variable resistor is applied to a series inductor (or a shunt inductor), in order to reduce the quality factor Q of the resonant network and therefore reduce the amount of amplitude peaking. For this reason, the resistor may also be referred to as a "de-Qing" circuit. However, in practice, the de-Qing circuit is unlikely to be implemented as a simple fixed resistor (e.g., a polysilicon resistor), instead being implemented as a fixed resistor and a MOS transistor operating in triode region connected in series, or as a MOS transistor only. Such de-Qing circuit will load non-negligibly the amplifier's output nodes, thus impairing the amplifier's transfer function (i.e., its bandwidth and peaking) in both off and on configurations. As such, the use of the de-Qing circuit described above is not feasible for very high frequency applications.

Another common technique of tuning amplitude peaking of a broadband amplifier is to include a tuneable capacitor connected between the emitter terminals of a bipolar junction transistor differential pair (or, in the case of field-effect transistors being used, between the source terminals for example). The tuneable capacitor may consist of n parallel units, each of them individually digitally controlled, therefore achieving different peaking combinations. Unfortunately, such approach significantly impairs the amplifier's linearity.

In contrast, the present invention does not cause any loading of the output nodes of the amplifier. In particular, the peaking inductor of the present invention is tuned via magnetic coupling to another inductor (i.e., a secondary inductor), which is connected in parallel to a tuneable impedance, thus realising a wideband radio frequency transformer configured as an impedance converter. As a result, there is nothing physically connected in parallel to the peaking inductor which may detrimentally load the amplifier (i.e., parasitic capacitances), which would impair the amplifier's achievable bandwidth and peaking.

Furthermore, rather than tuning the quality factor of an inductor by connecting a variable resistor in parallel to it, as it in current state of the art solutions, the proposed invention tunes the value of the inductor by virtue of the magnetic coupling to the secondary inductor and a tuneable impedance, such as a tunable resistive element, connected in parallel to it.

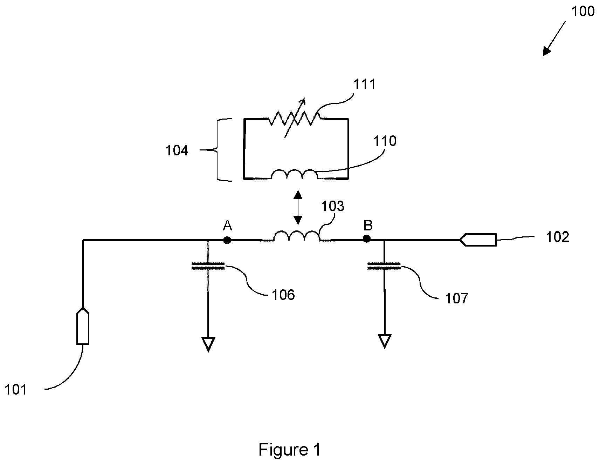

Figure 1 is a schematic representation of a resonance network according to an example. The resonance network 100 is suitable for use as part of an amplifier, such as, for example, a broadband amplifier, a transimpedance amplifier, or a driver amplifier. The resonance network 100 comprises an input terminal 101 and an output terminal 102. The input terminal 101 and the output terminal 102 may be realised by transistors, but could also be realised by trans-conductors or generally current generators. The resonance network 100 comprises a resonant circuit comprising a first inductor 103 and, for instance, two capacitors 106 and 107, as shown exemplarily in Figure 1, wherein the resonant circuit is connected between the input terminal 101 and the output terminal 102. The resonance network 100 further comprises a tuning circuit 104 comprising a second inductor 110 magnetically coupled to the first inductor 103, and a tunable resistive element 111 connected in parallel to the second inductor 110.

Since the second inductor 110 is magnetically coupled to the first inductor 103, a broadband RF transformer is realised. According to an example, the first inductor 103 is the inductor that is tuned and used to create peaking in the overall amplifier transfer function, while the second inductor 110 is connected to the tunable resistive element 111 to change an equivalent inductance seen between node A and node B.

By tuning the tunable resistive element 111, and by virtue of the magnetic coupling between the first inductor 103 and the second inductor 110, the equivalent inductance between the nodes A and B can be tuned. Compared to the current state of the art solutions, the proposed technique does not detrimentally load the first inductor 103, as there is nothing physically connected between the nodes A and B, other than the first inductor 103. In other words, when the tunable resistive element 111 is 'off' (i.e., set to a very high resistive value or has a very large impedance), the equivalent inductance between the nodes A and B is approximately equal to a value of the inductance of the first inductor 103. Consequently, when the tunable resistive element 111 is 'on' (i.e., set to a very low resistive value or has a very small impedance), the equivalent inductance between the nodes A and B is lower than the inductance of the first inductor 103. Compared to the prior art solutions, this configuration does not degrade the bandwidth and the peaking of the amplifier transfer function in both off and on configurations of the tunable resistive element 111.

The tunable resistive element 111 may be implemented in one or more of several different ways. For example, the tunable resistive element 111 can comprise a single variable resistor. A resistance of the single variable resistor can be controlled in a continuous fashion (i.e., analogue control) by an analogue control voltage.

In an example, the tunable resistive element 111 can comprise multiple smaller units (e.g., multiple variable resistors) arranged in parallel and each controlled using a dedicated control voltage (i.e., forming a segmented topology). In an example, respective control voltages can be provided for the multiple variable resistors. Accordingly, these independent control voltages may comprise analogue control voltages such that one or more of the voltages may take any value within a continuous range, and/or discrete control voltages such that one or more of the voltages may be selected from multiple discrete values, which can be the extreme values of a certain voltage range for example, thus realising a segmented analogue-tuned or a discretetuned topology.

In an example, the tunable resistive element 111 may comprise a MOS transistor or a bipolar junction transistor (BJT). That is, channel resistance of a MOS transistor or BJT can be leveraged (e.g., varied, modified or regulated) to provide a tunable resistive element. Accordingly, a MOS transistor or BJT can effectively be used as a switch. According to an example, a tunable resistive element 111 may thus be implemented as a MOS and/or BJT transistor used as a switch, or may comprise one or more physical resistors, which can, in some implementations, be provided in series with or parallel to a switch.

As discussed above, deploying a tunable inductor within the resonant peaking network of a broadband amplifier enables a desired amount of amplitude peaking tunability to be provided without any penalty in terms of maximum achievable peaking, bandwidth, and linearity.

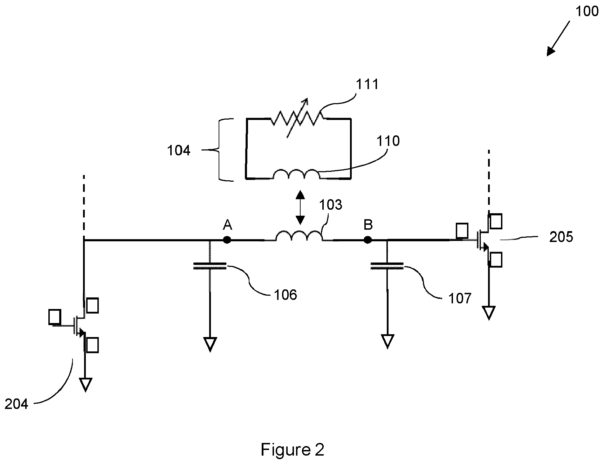

Figure 2 is a schematic representation of a resonance network according to another example. Figure 2 builds on the resonance network shown in Figure 1. The same elements in Figures 1 and 2 share the same reference signs and function likewise. In Figure 2, the input terminal 101 of Figure 1 may comprise an input terminal (for example, a collector terminal or a drain terminal) of a first transistor 204, or an output terminal of the first transistor 204. The output terminal 102 may comprise a control terminal of a second transistor 205. While a source (emitter) terminal of the first transistor 204 is shown to be connected to ground in Figure 2, the invention is not limited thereto. The skilled person would appreciate that, for example, if the first transistor 204 comprises a cascode or a common emitter transistor, the source terminal will not be connected to ground. The first transistor 204 and the second transistor 205 may comprise field-effect transistors (FETs) and/or bipolar junction transistors (BJTs).

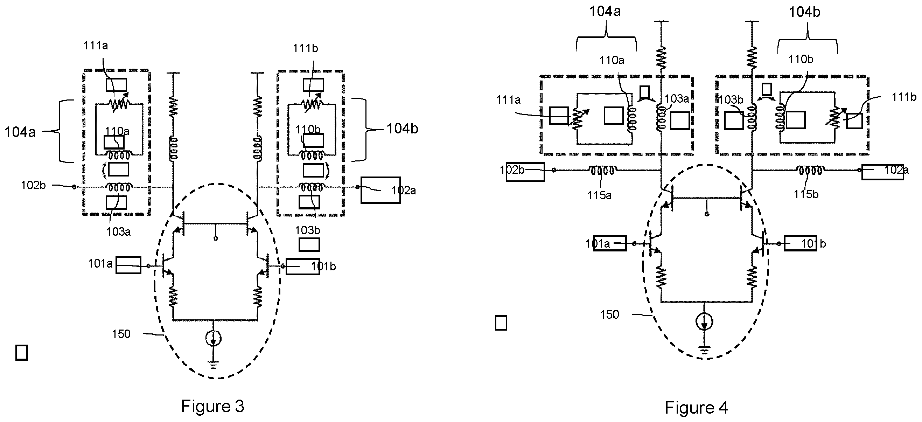

Figure 3 is a schematic representation of a resonance network according to another example. As before, the same reference signs refer to the same elements as those present in previous figures and described above. In particular, the tuning circuit 104 of Figure 1 may be developed around a series inductance of a triple-resonance network. In the embodiment of Figure 3, the tuning circuit 104 may comprise a first tuning circuit 104a (comprising a tunable resistive element 111a and a second inductor 110a) and a second tuning circuit 104b (comprising a tunable resistive element 111b and a second inductor 110b). The second inductors 110a, 110b may be magnetically coupled to first inductors 103a, 103b, respectively, as in Figure 1.

The resonance network of Figure 3 may comprise input terminals 101a, 101b and output terminals 102a, 102b. According to examples, an amplifier active section, depicted generally at 150, is provided. The amplifier active section can comprise a cascoded topology. Such a topology can maximize the amplifier reverse isolation, bandwidth and improve stability. It will be appreciated that other amplifier active topologies may be provided.

Figure 4 is a schematic representation of a resonance network according to another example. The same elements in Figures 1 and 4 share the same reference signs and function likewise. In the embodiment of Figure 4, tuning may also be applied to another inductor within the resonant network, i.e., to a shunt inductor (for example, shunt inductors 115a, 115b). The arrangement of Figure 4 offers improved bandwidth and peaking, compared with prior art solutions.

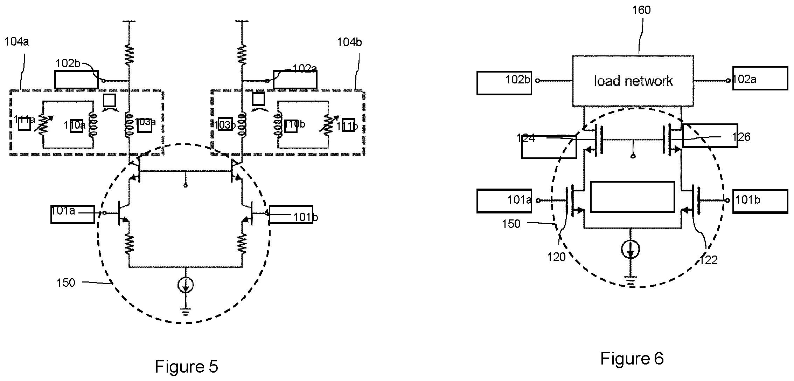

Figure 5 is a schematic representation of a resonance network according to yet another example. The same elements in Figures 1 and 5 share the same reference signs and function likewise. Compared to the embodiments of Figures 3 and 4, in Figure 5, the tuning circuit 104 (e.g., the first tuning circuit 104a, second tuning circuit 104b) may be developed around a first inductor 103(a/b), which is not a triple-resonant network. As before, the tuning circuit 104 comprises a second inductor 110(a/b) and a tunable resistive element 111(a/b).

In general, the present invention may be developed around any inductor within any peaking resonant load network of a broadband amplifier, depending on the required amount of peaking and bandwidth (i.e., the maximum achievable peaking and bandwidth of a broadband amplifier strongly depends on the configuration and size of the inductors within the load resonant peaking network. The proposed technique is suitable for integration in many different integrated circuit (IC) technologies, such as (but not limited to) BiCMOS and CMOS, as well as III-V compound technologies such as InP and GaAs, and others.

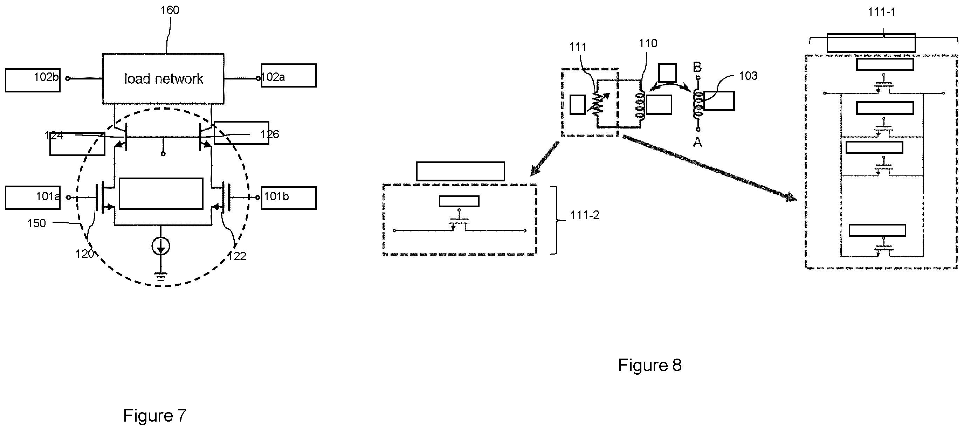

Figures 6 and 7 are schematic representations of a resonance network according to two more examples. The same elements in Figures 1, 6 and 7 share the same reference signs and function likewise. In the embodiments shown in Figures 6 and 7, a load network 160 may comprise any of the embodiments shown in Figures 1-5, while a transconductance network (i.e., anything other than the load network with tuneable peaking) may comprise a cascoded CMOS differential pair 120, 122. Cascode devices 124, 126 may comprise N-type MOS transistors (as shown in Figure 6), or bipolar transistors (as shown in Figure 7).

Figure 8 is a schematic representation of a resonance network according to yet another example. The same elements in Figures 1 and 8 share the same reference signs and function likewise. The embodiment of Figure 8 depicts two possible implementations of a tunable resistive element 111.

As discussed above, when a discrete tuning of the amplitude peaking of the broadband amplifier is preferred over a continuous (i.e., analogue) tuning, the tunable resistive element 111 may be implemented in a segmented topology, comprising multiple (n) smaller units arranged in parallel, as shown by 111-1. This configuration results in n combinations of amplitude peaking. Alternatively, a single, e.g., switchable or variable resistor may be used, as shown by 111-2.

The circuits of Figures 1 to 8 may comprise differential circuits. In other words, the skilled person would appreciate that the same concepts apply to single-ended topologies (i.e., identical to Figures 1 to 8 presented herein, but taking only "half' of the circuit).

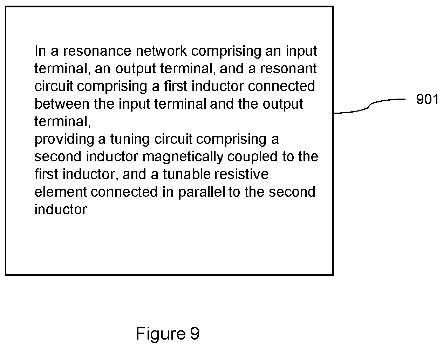

Figure 9 is a flow chart of a method of tuning amplitude peaking in a resonance network comprising an input terminal, an output terminal, and a resonant circuit comprising a first inductor connected between the input terminal and the output terminal, according to an example. The resonance network may comprise, for example, the resonance network 100 described above.

The method comprises, in block 901, providing a tuning circuit comprising a second inductor magnetically coupled to the first inductor, and a tunable resistive element connected in parallel to the second inductor. The method may further comprise varying a value of the tunable resistive element to change an equivalent inductance seen between the input terminal and the output terminal.

The preceding description has been provided to enable others skilled in the art to best utilize various aspects of the exemplary embodiments disclosed herein. This exemplary description is not intended to be exhaustive or to be limited to any precise form disclosed. The embodiments disclosed herein should be considered in all respects illustrative and not restrictive. Reference should be made to the appended claims and their equivalents in determining the scope of the instant disclosure.

## Claims

1. A resonance network (100) for an amplifier, comprising:
an input terminal (101) and an output terminal (102);
a resonant circuit comprising a first inductor (103), wherein the first inductor (103) is connected between the input terminal (101) and the output terminal (102); and
a tuning circuit (104) comprising a second inductor (110), wherein the second inductor (110) is magnetically coupled to the first inductor (103), and wherein the tuning circuit (104) comprises a tunable resistive element (111) connected in parallel to the second inductor (110).

2. The resonance network of claim 1, wherein the tuning circuit (104) is configured to modify a value of inductance of the first inductor (103) by varying a value of the tunable resistive element (111).

3. The resonance network of claim 1 or 2, wherein the tunable resistive element (111) comprises a variable resistor, wherein the variable resistor is configured to be controlled by a control voltage, whereby to provide a variable resistance.

4. The resonance network of claim 1 or 2, wherein the tunable resistive element (111) comprises a metal-oxide-semiconductor, MOS, transistor, and/or a bipolar junction transistor, BJT, (111-2) wherein a channel resistance of the MOS transistor and/or of the BJT can be varied, whereby to provide a variable resistance.

5. The resonance network of claim 3, wherein the variable resistor comprises a plurality of resistive units (111-1), wherein the plurality of resistive units (111-1) are each controllable by the control voltage.

6. The resonance network of claim 3 or 5, wherein the control voltage comprises an analogue control voltage or a discrete control voltage.

7. The resonance network of any preceding claim, comprising a plurality (104a; 104b) of resonant circuits, wherein the plurality of resonant circuits are connected to one another in series or in parallel.

8. The resonance network of claim 7, further comprising a shunt inductor (115a, 115b) or an inductor in series with the input terminal and the output terminal.

9. The resonance network of any preceding claim, further comprising at least one differential pair of transistors (120; 122).

10. The resonance network of claim 9, wherein the at least one differential pair of transistors (120; 122) comprise cascode transistors.

11. An amplifier comprising a resonance network (100) of any one of claims 1 to 10.

12. The amplifier of claim 11, wherein the amplifier comprises multiple resonance networks, wherein the multiple resonance networks are connected to one another in parallel or in series.

13. The amplifier of claim 11 or 12, wherein the amplifier comprises one of a broadband amplifier, a transimpedance amplifier, and a driver amplifier.

14. A method of tuning amplitude peaking in a resonance network (100) for an amplifier, the resonance network comprising an input terminal (101), an output terminal (102), and a resonant circuit, wherein the resonant network comprises a first inductor (103) connected between the input terminal (101) and the output terminal (102), the method comprising:
providing a tuning circuit (104), wherein the tuning circuit comprises a second inductor (110) magnetically coupled to the first inductor (103), and a tunable resistive element (111) connected in parallel to the second inductor (110); and
varying a value of the tunable resistive element (111) to change a value of inductance of the first inductor (103).

15. The method of claim 14, wherein the tunable resistive element (111) comprises a variable resistor and/or a metal-oxide-semiconductor, MOS, transistor and/or a bipolar junction transistor, BJT, (111-2) the method further comprising:
varying a value of the variable resistor using a control voltage; and/or
varying a value of a channel resistance of the MOS transistor and/or of the BJT.

## Amended claims

### Amended claims in accordance with Rule 137(2) EPC.

1. A resonance network (100) for an amplifier, comprising:
an input terminal (101) and an output terminal (102);
a resonant circuit comprising a first inductor (103), wherein the first inductor (103) is connected between the input terminal (101) and the output terminal (102); and
a tuning circuit (104) comprising a second inductor (110), wherein the second inductor (110) is magnetically coupled to the first inductor (103), and wherein the tuning circuit (104) comprises a tunable resistive element (111) connected in parallel to the second inductor (110);
wherein the tunable resistive element (111) comprises multiple smaller units arranged in parallel and each controlled using a dedicated control voltage.

2. The resonance network of claim 1, wherein the tuning circuit (104) is configured to modify a value of inductance of the first inductor (103) by varying a value of the tunable resistive element (111).

3. The resonance network of claim 1 or 2, wherein the tunable resistive element (111) comprises a variable resistor, wherein the variable resistor is configured to be controlled by a control voltage, whereby to provide a variable resistance.

4. The resonance network of claim 1 or 2, wherein the tunable resistive element (111) comprises a metal-oxide-semiconductor, MOS, transistor, and/or a bipolar junction transistor, BJT, (111-2) wherein a channel resistance of the MOS transistor and/or of the BJT can be varied, whereby to provide a variable resistance.

5. The resonance network of claim 3, wherein the variable resistor comprises a plurality of resistive units (111-1), wherein the plurality of resistive units (111-1) are each controllable by the control voltage.

6. The resonance network of claim 3 or 5, wherein the control voltage comprises an analogue control voltage or a discrete control voltage.

7. The resonance network of any preceding claim, comprising a plurality (104a; 104b) of resonant circuits, wherein the plurality of resonant circuits are connected to one another in series or in parallel.

8. The resonance network of claim 7, further comprising a shunt inductor (115a, 115b) or an inductor in series with the input terminal and the output terminal.

9. The resonance network of any preceding claim, further comprising at least one differential pair of transistors (120; 122).

10. The resonance network of claim 9, wherein the at least one differential pair of transistors (120; 122) comprise cascode transistors.

11. An amplifier comprising a resonance network (100) of any one of claims 1 to 10.

12. The amplifier of claim 11, wherein the amplifier comprises multiple resonance networks, wherein the multiple resonance networks are connected to one another in parallel or in series.

13. The amplifier of claim 11 or 12, wherein the amplifier comprises one of a broadband amplifier, a transimpedance amplifier, and a driver amplifier.

14. A method of tuning amplitude peaking in a resonance network (100) for an amplifier, the resonance network comprising an input terminal (101), an output terminal (102), and a resonant circuit, wherein the resonant network comprises a first inductor (103) connected between the input terminal (101) and the output terminal (102), the method comprising:
providing a tuning circuit (104), wherein the tuning circuit comprises a second inductor (110) magnetically coupled to the first inductor (103), and a tunable resistive element (111) connected in parallel to the second inductor (110); and
varying a value of the tunable resistive element (111) to change a value of inductance of the first inductor (103);
wherein the tunable resistive element (111) comprises multiple smaller units arranged in parallel and each controlled using a dedicated control voltage.

15. The method of claim 14, wherein the tunable resistive element (111) comprises a variable resistor and/or a metal-oxide-semiconductor, MOS, transistor and/or a bipolar junction transistor, BJT, (111-2) the method further comprising:
varying a value of the variable resistor using a control voltage; and/or
varying a value of a channel resistance of the MOS transistor and/or of the BJT.
